# FASCICULE DE BREVET EUROPEEN

(11) **EP 2 421 792 B1**
(45) Date de publication et mention de la délivrance du brevet: **08.05.2013**
(21) Numéro de dépôt: 10713997.4
(22) Date de dépôt: 20.04.2010
(51) Int. Cl.: B81C 1/00

(54) **PROCEDE DE REALISATION D'UNE CAVITE DANS L'EPAISSEUR D'UN SUBSTRAT POUVANT FORMER UN SITE D'ACCUEIL DE COMPOSANT**
VERFAHREN ZUR AUSBILDUNG EINES HOHLRAUMS IM KÖRPER EINES SUBSTRATS, DER EINE STELLE ZUR AUFNAHME EINER KOMPONENTE BILDEN KANN
METHOD FOR MAKING A CAVITY IN THE BODY OF A SUBSTRATE CAPABLE OF FORMING A SITE FOR RECEIVING A COMPONENT

(30) Priorité: 21.04.2009 FR 0952598
(43) Date de publication de la demande: 29.02.2012
(73) Titulaire: Commissariat à l'Énergie Atomique et aux Énergies Alternatives, 75015 Paris (FR)
(72) Inventeur: SAINT-PATRICE, Damien, F-26120 Chabeuil (FR); BOLIS, Sébastien, F-38920Crolles (FR); JACQUET, Fabrice, F-38220 Saint Pierre De Mesage (FR)
(74) Mandataire: Ilgart, Jean-Christophe
(86) Numéro de dépôt international: PCT/EP2010/055185
(87) Numéro de publication internationale: WO 2010/122015

(56) Documents cités:
- EP-A- 1 635 625
- WO-A-00/26957
- WO-A-2008/023824
- US-A1- 2005 017 276
- US-A1- 2005 105 184
- US-A1- 2007 190 691

## Description

### DOMAINE TECHNIQUE

La présente invention concerne le domaine des micro-systèmes, électroniques ou électromécaniques ou optiques, ou optoélectroniques, ou de mesure chimique ou biologique, et prévoit un procédé de réalisation dans un substrat d'une ou plusieurs cavités pouvant former des sites d'accueils d'un ou plusieurs composants électroniques, optiques, ou de détection chimique ou biologique, ou de type micro-systèmes électromécaniques MEMS (soit Micro-Electro-Mechanical Systems en anglais) ou opto-électromécaniques MOEMS (soit Micro-Opto-Electro-Mechanical Systems en anglais) solidaires du substrat.

### ART ANTERIEUR

Dans le domaine de la microélectronique et des microsystèmes, la réalisation de cavités dans un substrat, par exemple par gravure sèche ou laser, afin par exemple de former des sites d'accueil de composants, est connue.

La réalisation de telles cavités peut nécessiter l'élimination d'une quantité importante de matériau, ce qui induit des durées de gravures importantes.

L'invention propose de pallier ce problème.

**US2005/0017276**décrit un procédé de fabrication d'un dispositif électronique doté d'au moins une cavité. WO00/26957 décrit un procédé de fabrication d'un substrat en céramique, à couche multiple. **US2005/0105184**décrit un procédé de fabrication de structures à membranes. EP1 635 625 décrit un procédé de fabrication d'un substat.

### EXPOSÉ DE L'INVENTION

L'invention concerne un procédé de réalisation d'un micro-dispositif doté d'au moins une cavité susceptible de former un site d'accueil de composant(s), la cavité étant réalisée dans l'épaisseur d'au moins un substrat, le procédé comprenant des étapes de :
a) réalisation dans au moins un premier substrat assemblé à un deuxième substrat par l'intermédiaire d'une interface, d'au moins une première tranchée autour d'au moins un bloc sacrificiel du premier substrat, par gravure du premier substrat, et de manière à dévoiler ladite interface ;
b) retrait dudit bloc sacrificiel de façon à réaliser au moins une première cavité dans le premier substrat.

La ou les cavités formées dans le premier substrat peuvent être prévues pour former des sites d'accueil de composants.

Le premier substrat et le deuxième substrat sont être assemblés par l'intermédiaire d'une interface de collage. Le collage peut être un collage moléculaire ou un collage par apport de matière.

L'interface de collage entre le premier substrat et le deuxième substrat est discontinue et comprend des zones à base d'au moins un matériau de collage, et d'autres zones formant un espace vide entre le premier substrat et le deuxième substrat.

L'invention utilise donc une interface de collage discontinue. Cela permet un retrait plus aisé du bloc sacrificiel puisque, dans ce cas, le retrait ne nécessite pas de gravure.

Selon un mode de réalisation particulier de l'invention, l'interface de collage est une interface de collage moléculaire qui est structurée de façon à avoir des zones de collage moléculaire et des zones de vide, sans collage moléculaire.

Les zones formant un espace vide entre le premier et le deuxième substrat, peuvent avoir une répartition prévue en fonction de celle du bloc sacrificiel et être formées en regard de ce dernier.

Cela peut permettre un retrait du bloc sacrificiel plus aisé.

L'interface de collage discontinue, entre le premier substrat et le deuxième substrat, peut comprendre des zones à base d'au moins un premier matériau de collage, et des zones à base d'au moins un deuxième matériau de collage, en particulier un matériau fusible, situées en regard des blocs sacrificiels.

Le deuxième matériau de collage peut être prévu pour réaliser un collage provisoire ou temporaire et peut être destiné à être retiré ultérieurement.

Selon une possibilité de mise en oeuvre, l'interface entre le premier substrat et le deuxième substrat peut comporter des zones conductrices de l'électricité.

Ainsi, une connexion électrique entre le premier substrat et le deuxième substrat peut être réalisée.

Selon une possibilité, le procédé peut comprendre en outre : la réalisation d'au moins une autre tranchée dans le deuxième substrat en regard dudit bloc sacrificiel ou dans le prolongement de ladite première cavité.

Cette autre tranchée peut être réalisée autour d'un autre bloc sacrificiel situé en regard dudit bloc sacrificiel. Le procédé peut alors comprendre en outre le retrait dudit autre bloc sacrificiel de manière à former une cavité dans le deuxième substrat en regard dudit bloc sacrificiel ou dans le prolongement de ladite première cavité.

Le retrait du bloc sacrificiel peut être réalisé par gravure partielle de l'interface de collage.

Après la réalisation de la tranchée, le procédé peut comprendre la formation d'une couche de protection recouvrant le premier substrat, puis, préalablement à l'étape b), le retrait de la couche de protection sur le bloc sacrificiel. Ainsi, le bloc sacrificiel n'est pas protégé par cette couche de protection et peut être retiré.

Selon une possibilité, le premier substrat et/ou le deuxième substrat peuvent être dotés d'éléments conducteurs traversant, en contact avec lesdites zones conductrices.

A l'étape a), la formation des tranchées peut comprendre la réalisation de motifs dans le premier substrat de manière à former une mire ou un repère visuel autour des blocs sacrificiels, ces motifs étant destinés à indiquer le centre des cavités. Ces motifs peuvent être également destinés à former des moyens de guidage mécanique. Dans ce cas, un auto-centrage d'un composant destiné à être placé dans la cavité et s'appuyant sur les moyens de guidage mécanique, peut être mis en oeuvre.

Selon une possibilité de mise en oeuvre, le premier substrat et le deuxième substrat peuvent être formés de matériaux différents.

Selon une possibilité, le deuxième substrat peut être assemblé à un troisième substrat par l'intermédiaire d'une autre interface, le procédé comprenant en outre :
- la réalisation d'au moins une autre tranchée, traversant le bloc sacrificiel du premier substrat, et prolongée dans le deuxième substrat autour d'au moins un bloc sacrificiel du deuxième substrat jusqu'à l'autre interface entre le deuxième,substrat et le troisième substrat ;
- la réalisation d'au moins une tranchée autour d'au moins un bloc sacrificiel du troisième substrat, par gravure, de manière à dévoiler l'interface entre le deuxième substrat et le troisième substrat, l'étape b) comprenant en outre des blocs sacrificiels du deuxième substrat et du troisième substrat de façon à réaliser une cavité traversant le premier substrat, le deuxième substrat et le troisième substrat.

Le procédé peut comprendre en outre, après l'étape b), la réalisation d'au moins un élément dans la première cavité. Cet élément peut être un composant électronique, RF, optoélectronique, un détecteur chimique ou biologique ou un élément chimique ou biologique.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels :
- les figures 1A-1G illustrent un exemple de procédé de réalisation d'un micro-dispositif comprenant des substrats assemblés entre eux par l'intermédiaire d'une couche de collage, et doté de cavités réalisées dans l'épaisseur d'au moins un des substrats et susceptibles de former des sites d'accueils de composants ;
- les figures 2A-2D, et 3 illustrent un autre exemple de procédé de réalisation d'un micro-dispositif comprenant des substrats collés entre eux par l'intermédiaire d'une interface de collage discontinue, et doté de cavités formées dans l'épaisseur d'au moins un des substrats et susceptibles de former des sites d'accueils de composants ;
- les figures 4A-4B illustrent un exemple de procédé de retrait de blocs sacrificiels qui peut être mis en oeuvre au cours d'un procédé suivant l'invention ;
- les figures 5A-5D illustrent une variante de procédé suivant l'invention ;
- la figure 6 illustre un exemple de micro-dispositif mis en oeuvre à l'aide d'un procédé suivant l'invention comprenant des substrats assemblés entre eux, et doté de sites d'accueils de composants, au moins un des substrats étant pourvu de vias conducteurs traversant son épaisseur ;
- la figure 7 illustre un exemple de micro-dispositif mis en oeuvre à l'aide d'un procédé suivant l'invention, comprenant des substrats assemblés entre eux, et doté de composants logés dans des sites d'accueils dans l'épaisseur d'au moins un des substrats ;
- les figures 8A et 8B illustrent un exemple de réalisation d'un micro-dispositif mis en oeuvre suivant l'invention, dans lequel des composants sont logés dans des cavités formant des sites d'accueil dans l'épaisseur d'au moins un substrat, les composants étant enrobés dans un matériau de protection ;
- les figures 9A et 9B illustrent un exemple de réalisation d'un micro-dispositif mis en oeuvre suivant l'invention, doté de sites d'accueil formés dans l'épaisseur de trois substrats collés entre eux ;
- les figures 10A et 10B illustrent des étapes de réalisation de sites d'accueil de composants dans l'épaisseur de substrats assemblés entre eux, au cours desquelles des motifs spécifiques sont formés et destinés à servir de repères indiquant le centre des sites dans lesquels les composants sont destinés à être placés ou de moyens de guidage des composants afin de guider les composants lorsqu'on dispose ces derniers dans les sites d'accueil ;
- les figures 11 à 13 illustrent différents exemples de dispositifs mis en oeuvre suivant l'invention et formés de substrats assemblés dans lesquels des sites d'accueil de composants ont été réalisés.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

### EXPOSÉ DÉTAILLÉ DE MODES DE RÉALISATION PARTICULIERS

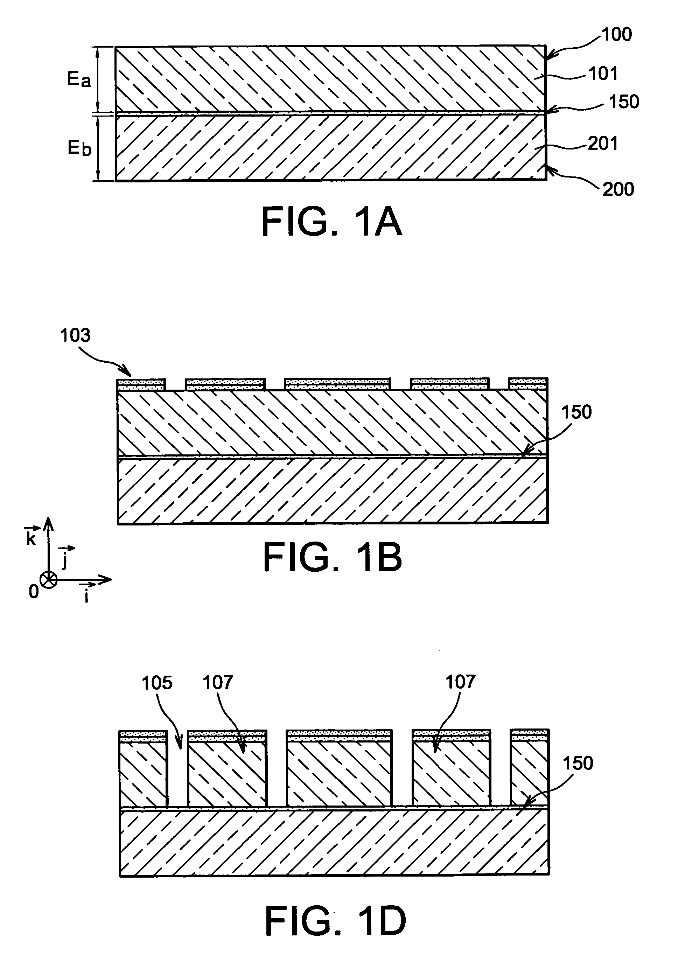

Un exemple de procédé de réalisation d'un dispositif microélectronique suivant l'invention, va à présent être donné en liaison avec les figures 1A-1G (le dispositif étant vu sur les figures 1A-1B et 1D-1G selon une vue en coupe transversale A'-A, seuls les éléments situés dans le plan de coupe étant représentés sur ces figures).

Le matériau de départ de ce procédé peut être un substrat 100, à base d'un premier matériau 101, qui peut être semi-conducteur, tel que du silicium ou du Germanium et avoir une épaisseur Ea qui peut être comprise entre 10 µm et 1000 µm.

Ensuite, on joint au substrat 100, un deuxième substrat 200, par exemple par un procédé de collage tel qu'un collage moléculaire ou un collage par apport de matière.

Le substrat 200, peut être également à base d'au moins un deuxième matériau 201, qui peut être semi-conducteur tel que du Si ou du Ge, et avoir une épaisseur Eb qui peut être comprise entre 10 µm et 1000 µm, par exemple entre 10 et 1000 µm.

Selon une possibilité de réalisation, le deuxième substrat 200, peut être à base d'un matériau 201 différent du matériau 101 du substrat 100 par exemple un matériau semi-conducteur différent de celui du premier substrat 100.

D'autres assemblages de matériaux peuvent être réalisés.

Selon d'autres exemples de réalisation, un assemblage d'un premier substrat en verre et d'un deuxième substrat en verre, ou d'un substrat en verre et d'un substrat en silicium, ou d'un substrat en céramique et d'un substrat en verre, ou d'un substrat en verre et d'un substrat polymère, ou d'un substrat en Si et d'un substrat polymère, peuvent être effectués.

Le collage des substrats 100 et 200 peut être un collage dit « pleine plaque », dans lequel, à l'interface de collage se trouve une couche continue 150 de collage, en contact entre les deux substrats 100 et 200.

Dans le cas où les deux substrats 100 et 200 sont à base de Si et joints entre eux par collage, l'interface de collage peut être par exemple une couche 150 d'oxyde de silicium ou plusieurs couches 150 d'oxyde de silicium empilées, ce de manière à former des interfaces de type silicium/oxyde de silicium et éventuellement une interface oxyde de silicium/oxyde de silicium (figure 1A).

Ensuite, on peut réaliser un masque 103 sur le substrat 100, en vue de graver ce dernier.

Le masque de gravure 103 peut être par exemple à base d'une couche de résine reposant sur une couche d'oxyde de silicium qui peut être formée par dépôt tel qu'un dépôt de type PECVD (PECVD pour « plasma enhanced chemical vapor déposition ») ou par oxydation thermique.

Des étapes de photolithographie, puis de gravure, peuvent permettre de définir les motifs du masque de gravure 103 (figure 1B).

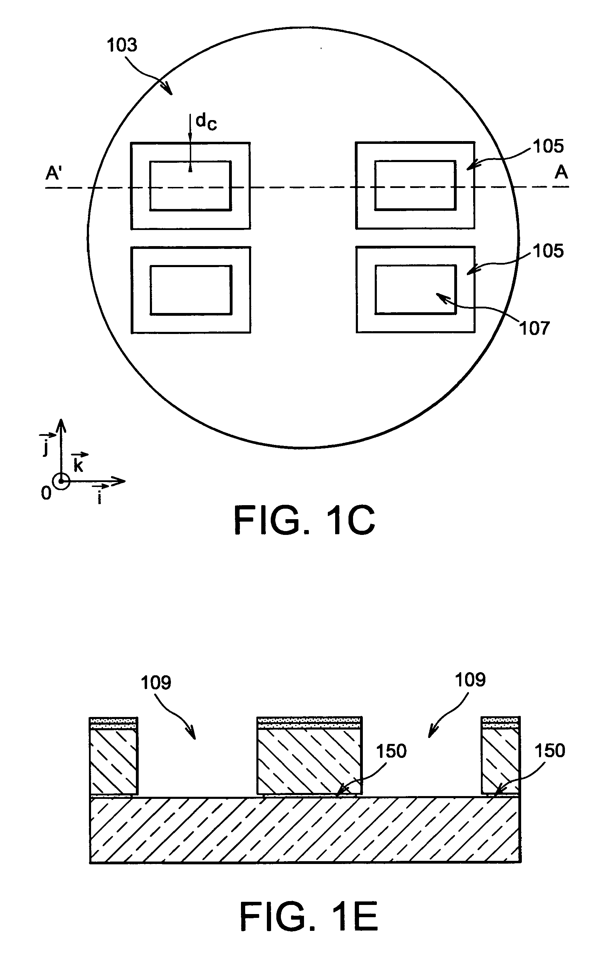

Ensuite, on forme une ou plusieurs tranchées 105 par gravure du substrat 100 à travers le masque dans le premier substrat 100, entourant des blocs 107 de ce dernier, que l'on appellera « blocs sacrificiels ». Les tranchées 105 forment chacune un contour autour d'un bloc 107 sacrificiel du substrat 100, qui est détouré et destiné à être retiré ultérieurement (figure 1C).

Les tranchées 105 sont prévues de manière à dévoiler la couche de collage 150. Les tranchées 105 peuvent avoir une profondeur au moins égale à Ea et déboucher sur l'interface de collage entre les substrats, ou éventuellement traverser cette interface. Les tranchées 105 peuvent avoir une dimension critique de de l'ordre par exemple de 10 µm lorsqu'elles sont réalisées par gravure DRIE d'un substrat ayant une épaisseur Ea, par exemple de l'ordre de 720 µm. Par « dimension critique », on entend la plus petite dimension d'un motif réalisé dans une couche ou un empilement de couches hormis son épaisseur (la dimension critique étant mesurée sur ces figures dans une direction parallèle à celle du plan [O;*̅i̅*̅;*̅j̅*̅] du repère orthogonal [O; *̅i̅*̅ ; *̅j̅*̅ ; *̅k̅*̅]). Selon une possibilité (non représentée sur la figure 1C), les tranchées 105 peuvent éventuellement déboucher dans le deuxième substrat 200.

La gravure des tranchées 105 peut être effectuée à l'aide d'un procédé de gravure par laser ou par une gravure profonde plasma. Dans un cas par exemple, où les tranchées sont réalisées par une gravure, telle qu'une gravure ionique réactive profonde également appelée DRIE (DRIE pour « Deep Reactive Ion Etching »), une sélectivité importante peut être obtenue par rapport à l'oxyde de silicium de la couche 150 de collage, de sorte que la gravure peut s'arrêter sur l'interface de collage lorsque celle-ci est à base d'oxyde de silicium (figure 1D).

Ensuite, on effectue un retrait des blocs sacrificiels 107.

Le retrait des blocs sacrificiels 107 peut être réalisé par gravure de la couche 150 ou des couches 150 de collage à l'interface entre les substrats 100 et 200 à travers les tranchées 105.

Ainsi, on retire le matériau de la couche de collage 150 sous les blocs sacrificiels 107.

Dans le cas où la couche de collage 150 ou les couches de collage 150 sont à base de SiO₂, une gravure par exemple à l'aide de HF peut être réalisée.

Le retrait des blocs sacrificiels 107 permet de former des cavités 109 dans le premier substrat 100. Ces cavités 109 peuvent former des sites d'accueil d'un ou plusieurs composants qui peuvent être électronique(s), et/ou optique(s), et/ou optoélectronique(s), et/ou électro-mécaniques, et/ou de détection chimique ou biologique (figure 1E).

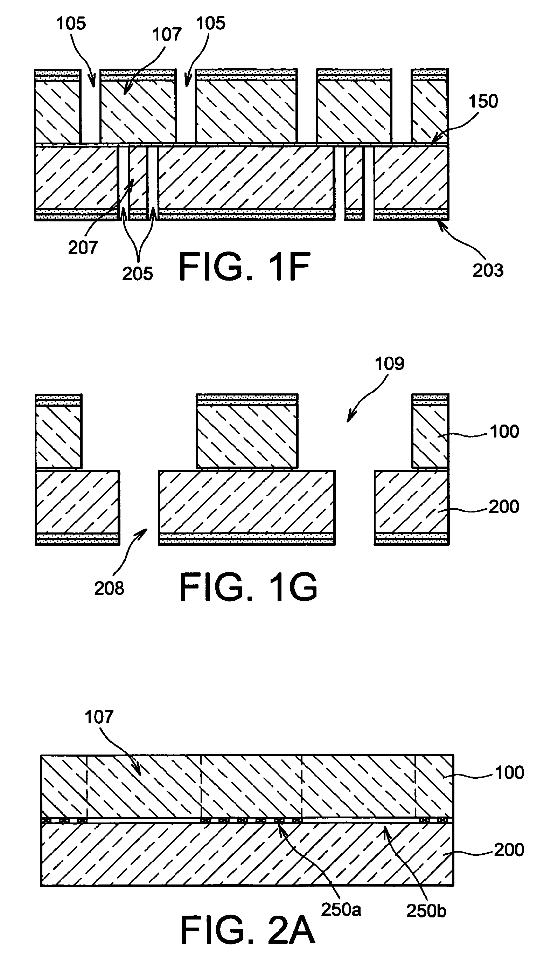

Selon une possibilité (non représentée sur les figures 1E et 1F), des tranchées secondaires peuvent être formées dans les blocs sacrificiels 107, afin de faciliter ultérieurement la gravure de l'interface de collage 150 et/ou éviter une sur-gravure.

Dans le cas d'une application optique, et en particulier lorsque les cavités 109 traversent le premier substrat 100, les composants optiques formés dans les cavités 109 peuvent être par exemple des lentilles, ou des filtres tels que par exemples de filtres IR.

Dans le cas d'une application électronique, les composants électroniques formés dans les cavités peuvent être par exemple des circuits intégrés, ou des mémoires, ou des micro-processeurs, ou des convertisseurs.

Selon d'autres possibilités, les composants peuvent être des MEMS, ou par exemple des Getter. Selon une autre possibilité, la structure réalisée peut être destinée à former un capot d'un composant MEMS.

Selon une variante, le procédé peut comprendre la formation d'autres tranchées 205 dans le deuxième substrat 200, situées entre les tranchées 105. Ces autres tranchées 205 peuvent être réalisées préalablement au retrait des blocs sacrificiels 107, en regard de ces derniers (figure 1F).

Les autres tranchées 205 peuvent être également réalisées autour de blocs 207 sacrificiels du deuxième substrat 200, de manière à former des contours autour de ces blocs 207. Les tranchées 205 peuvent être formées à travers un masque de gravure 203 déposé sur le deuxième substrat 200 et qui peut être semblable au masque 103 réalisé en vue de former les tranchées 205.

Les autres tranchées 205 peuvent être éventuellement formées en regard des tranchées 105 ou dans le prolongement de ces dernières.

Les tranchées 205 sont réalisées de sorte qu'un faible volume de matériau du deuxième substrat 200 est retiré autour des blocs sacrificiels 207. Les tranchées 205 peuvent avoir une profondeur égale à Eb, et une dimension critique de qui peut être par exemple de l'ordre de plusieurs micromètres.

La formation des autres tranchées 205, et un retrait des blocs sacrificiels 207 du deuxième substrat 200 permet de créer des ouvertures 209 dans le deuxième substrat 200, dans le prolongement des cavités 109 (figure 1G).

De même, selon une possibilité (non représentée), d'autres tranchées secondaires peuvent être formées dans les blocs sacrificiels 207 du deuxième substrat 200, afin de faciliter ultérieurement la gravure de l'interface de collage 150 et/ou éviter une sur-gravure.

Le retrait des blocs sacrificiels 207 peut, comme celui des blocs sacrificiels 107, être réalisé par gravure de la couche de collage 150. Dans le cas où la couche de collage 150 est à base de SiO₂, la gravure peut être réalisée par exemple à l'aide de HF.

Selon une autre possibilité de mise en oeuvre, le retrait des blocs sacrificiels 107 et 207 peut être réalisé simultanément, par gravure de la couche de collage 150 à travers les tranchées 209 et/ou les tranchées 109.

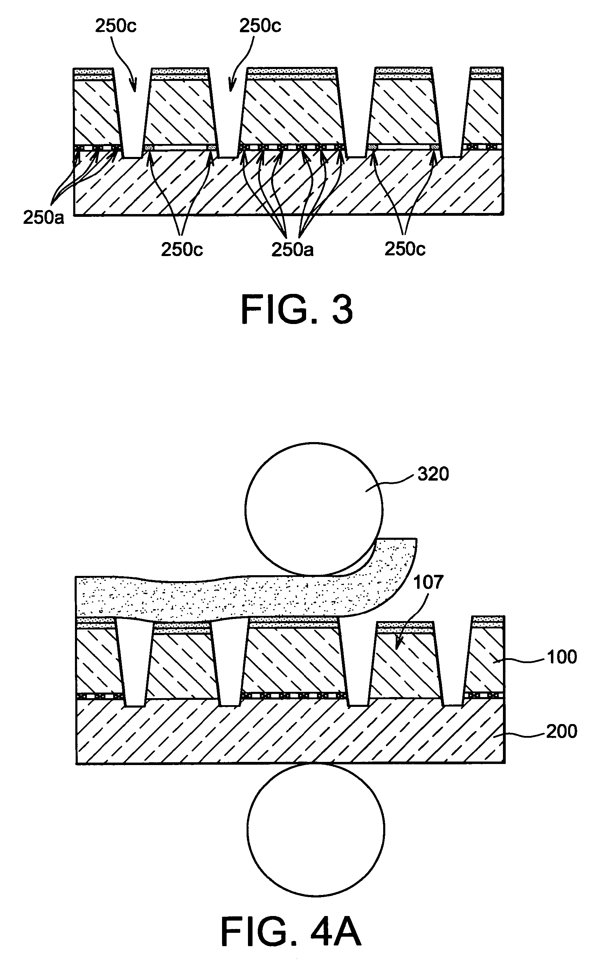

Selon une variante de l'exemple de réalisation qui vient d'être donné, on peut joindre les substrats 100 et 200 par collage, en réalisant cette fois une interface de collage discontinue entre le premier substrat 100 et le deuxième substrat 200. Les figures 2A-2D et 3 illustrent une telle variante.

L'interface discontinue peut être réalisée de sorte que certaines zones 250b de cette interface entre les deux substrats 100 et 200 ne comportent pas de matériau de collage et forment un espace vide entre les substrats 100 et 200, tandis que d'autres zones 250a à base d'un matériau de collage donné, assurent le collage entre les substrats 100 et 200.

Les zones 250b vides entre les deux substrats 100 et 200 peuvent être disposées en fonction de la répartition desdits blocs « sacrificiels » 107 du premier substrat 100, qui sont destinés à être supprimés. Les zones 250b peuvent être placées en regard desdits blocs « sacrificiels » 107 du premier substrat 100, de sorte que les blocs sacrificiels 107 du premier substrat 100 et le deuxième substrat 200 sont séparés par des zones 250b de vide (figure 2A).

Selon une possibilité de mise en oeuvre, les zones 250a de collage peuvent être à base d'un matériau conducteur électrique tel qu'un matériau métallique, ce qui peut permettre d'assurer une continuité électrique entre les substrats 100 et 200. Le matériau conducteur peut être par exemple un alliage métallique tel que de l'AuSn, ou à base de cuivre, ou par exemple formé de couches cuivre superposées.

Les substrats 100 et 200 collés peuvent être de natures différentes, éventuellement avec des coefficients respectifs de dilatation éloignés l'un de l'autre.

Ensuite, des étapes de réalisation d'un masque de gravure 103, puis de tranchées par gravure du premier substrat 100 à travers le masque de gravure 103, peuvent être effectuées, par exemple de la manière décrite précédemment en liaison avec les figures 1A-1D.

Les tranchées 105 sont réalisées de manière à dévoiler l'interface de collage par gravure et peuvent éventuellement être prolongées jusque dans le deuxième substrat 200, au-delà de l'interface de collage, par exemple de manière à traverser une épaisseur Ei contrôlée du deuxième substrat 200.

Les tranchées 105 peuvent être réalisées en regard des zones 250b, ou de manière à aboutir aux zones 250b, ou à traverser les zones 250b, qui, entre les deux substrats 100 et 200, ne comportent pas de matériau de collage.

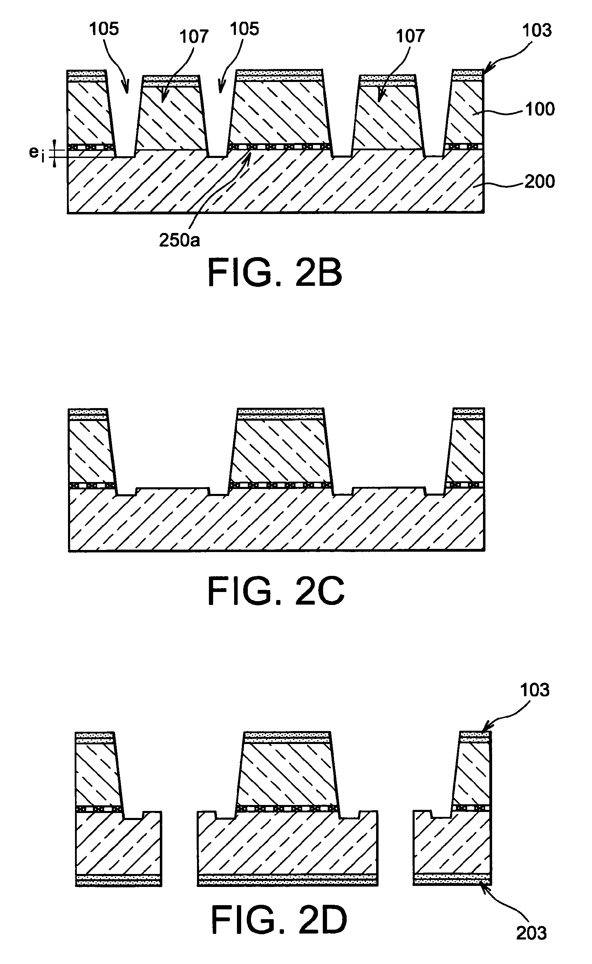

Lorsque les tranchées 105 sont formées de manière à entourer des blocs 107 sacrificiels du substrat 100 qui ne sont pas maintenus collées au substrat 200 par l'intermédiaire de zones 250a de collage, ces blocs 107 sacrificiels ne sont pas tenus mécaniquement par l'intermédiaire d'un matériau de collage. Ces blocs 107 sacrificiels peuvent ainsi être détachés et retirés plus aisément (figure 2B).

Selon une variante (non représentée), l'agencement des zones 250a et 250b de l'interface de collage et celui des tranchées 105, est prévu de sorte que les blocs sacrificiels 107 entourés par les tranchées 105, sont maintenus collés au substrat 200 par des zones de collage 250a situées à proximité des tranchées 105, tandis qu'un espace vide est prévu entre le centre des blocs sacrificiels 107 et le substrat 200. Ainsi, les blocs 107 peuvent être maintenus collés au substrat 200, tout en faisant en sorte que l'adhésion au substrat 200 soit suffisamment faible pour permettre de les retirer aisément ultérieurement.

Selon une autre variante (figure 3), l'interface de collage discontinue peut avoir été réalisée de sorte que certaines zones 250b de l'interface entre les deux substrats 100 et 200 ne comportent pas de matériau de collage et forment un espace vide entre les substrats 100 et 200, tandis que des zones 250a et 250c de matériaux de collage différents sont prévues.

Des zones 250a d'un premier matériau de collage et des zones 250c à base d'un deuxième matériau de collage, assurent le collage entre les substrats 100 et 200. Les zones 250a, 250c entre les deux substrats 100 et 200 sont réparties en fonction de celle de blocs sacrificiels 107 du substrat 100 destinés à être supprimés.

Le premier matériau des zones 250a peut être par exemple à base d'un matériau conducteur. Les blocs sacrificiels 107 peuvent être disposés en regard des zones 250c à base du deuxième matériau de collage. Le deuxième matériau de collage peut être avantageusement un matériau qui peut être retiré ultérieurement des substrats ou désolidarisé des substrats, par exemple à l'aide d'un solvant ou par échauffement. Le deuxième matériau de collage peut être par exemple une colle ou une résine de scellement.

Ainsi, le deuxième matériau de collage peut être prévu pour effectuer un collage temporaire et peut être destiné à être supprimé. Le deuxième matériau de collage peut être choisi comme un matériau qui peut être retiré de manière sélective vis-à-vis du premier matériau ou plus aisé à retirer que le premier matériau.

Dans le cas où le deuxième matériau de collage est un polymère de type résine ou colle, ce matériau peut être dissout à l'aide d'au moins un solvant par exemple à base d'acétone, d'acide nitrique fumant, ou d'un plasma par exemple à base de O₂ + SF₆.

L'agencement des zones 250c de l'interface de collage et celui des tranchées 105, est prévu de sorte que les blocs sacrificiels 107 entourés par les tranchées 105, sont maintenus collés au substrat 200 par les zones 250c à base du matériau fusible, un espace vide pouvant être prévu entre le centre des blocs sacrificiels 107 et le substrat 100, ce afin de maintenir provisoirement les blocs 107 collés au substrat 200, tout en permettant de les retirer aisément ultérieurement.

Ainsi, on a formé une interface de collage spécifique en regard des blocs sacrificiels, cette interface étant différente de celle prévue pour coller les autres zones des substrats 100 et 200. Cette interface de collage spécifique peut permettre de maintenir collés provisoirement les blocs sacrificiels 107. L'interface de collage spécifique peut être prévue pour être supprimée ou pour avoir une tenue mécanique suffisamment faible pour permettre la séparation ultérieure des blocs sacrificiels 107 du substrat 200.

Après gravure des tranchées 105, les blocs sacrificiels 107 à l'intérieur de ces dernières peuvent être retirés (figures 2C et 2D).

Le retrait des blocs sacrificiels 107 peut être effectué d'une manière semblable à celle décrite précédemment en liaison avec la figure 1E, dans lequel on effectue une gravure à travers les tranchées (figure 2C).

Le retrait des blocs sacrificiels 107 peut être effectué d'une manière semblable à celle décrite précédemment en liaison avec la figure 1G, en formant préalablement les tranchées 205 dans le deuxième substrat 200, puis en effectuant une gravure à travers les tranchées 105 et/ou les tranchées 205 (figure 2D).

Selon un mode de réalisation particulier non représenté, l'interface de collage entre les substrats 100 et 200 est une interface de collage moléculaire. Elle est structurée de façon à comporter des zones de collage moléculaire et des zones de vide, sans collage moléculaire.

Sur les figures 4A-4B, un autre exemple de procédé de retrait des blocs sacrificiels 107, est donné.

Il est possible de retirer les blocs sacrificiels en déposant un film adhésif 310 sur le substrat 100, en utilisant par exemple un équipement de laminage muni de rouleaux 320 permettant de disposer le film adhésif 310 sur le substrat 100 (figure 4A).

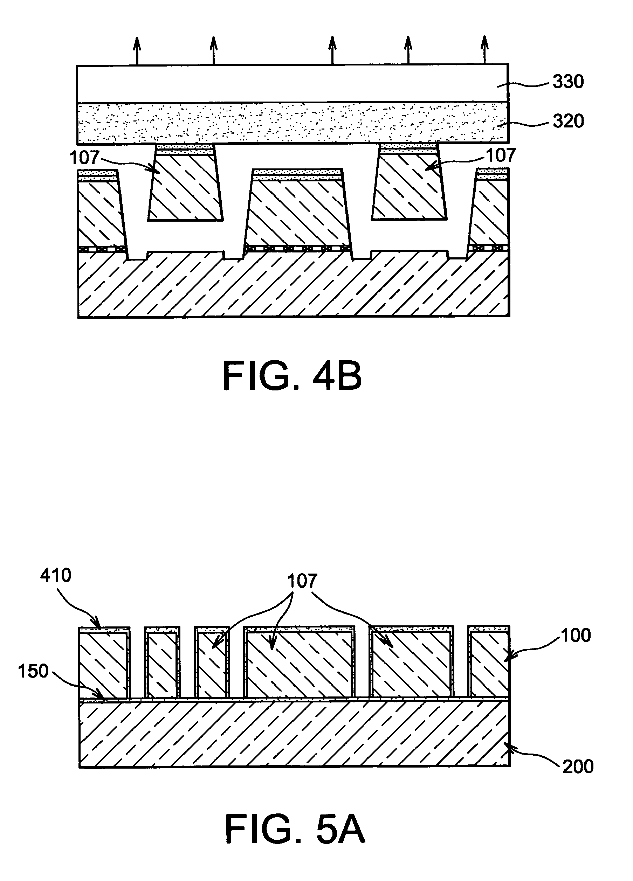

Ensuite à l'aide d'un support 330 mis en contact avec le film 320 et formant une poignée, on retire le fil adhésif 320 de manière à récupérer les blocs sacrificiels 107 (figure 4B).

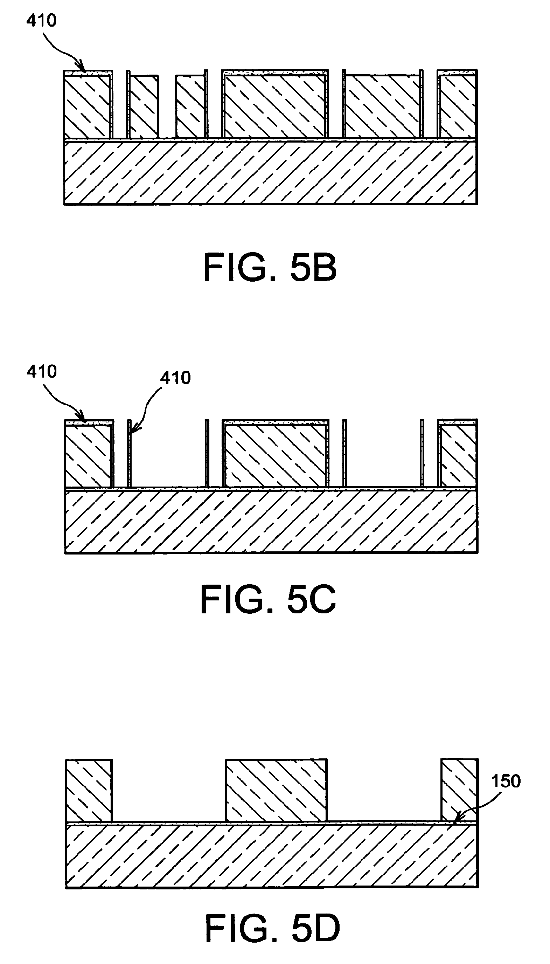

Un autre exemple de procédé de retrait des blocs sacrificiels, va à présent être donné en liaison avec les figures 5A-5D.

Selon cet autre exemple, on retire les blocs sacrificiels par gravure du matériau 101 à base duquel ces derniers sont formés.

Pour cela, une fois avoir réalisé les tranchées 105, on forme une couche de protection 410 recouvrant le substrat 100, les parois et le fond des tranchées (figure 5A). La couche de protection 410 peut être par exemple une couche à base de SiO₂, de l'ordre de 1 µm d'épaisseur. Cette couche de SiO₂ peut être réalisée par exemple, après avoir retiré le masque à gravure 103, par oxydation thermique du substrat 100 lors d'un recuit haute température. L'épaisseur de la couche de protection 410 peut être prévue inférieure à celle de la couche 150 de collage située à l'interface entre les deux substrats 100 et 200, en particulier dans le cas où la couche 150 de collage et la couche de protection sont formées d'un même matériau tel que du SiO₂.

On retire ensuite la couche de protection 410 localement dans une zone située au dessus des blocs sacrificiels 107 (figure 5B).

Puis, on grave les blocs sacrificiels 107. Lorsque le substrat 100 est à base de Si, cette gravure peut être réalisée par exemple à l'aide de KOH ou de TMAH (figure 5C).

Ensuite, on retire la couche de protection 410. Ce retrait peut être réalisé par exemple par gravure à l'aide d'une solution de HF.

Selon une variante de l'un ou l'autre des exemples de réalisation qui viennent d'être donnés, des éléments conducteurs communément appelés vias peuvent être prévus dans le premier substrat 100 et/ou le deuxième substrat 200.

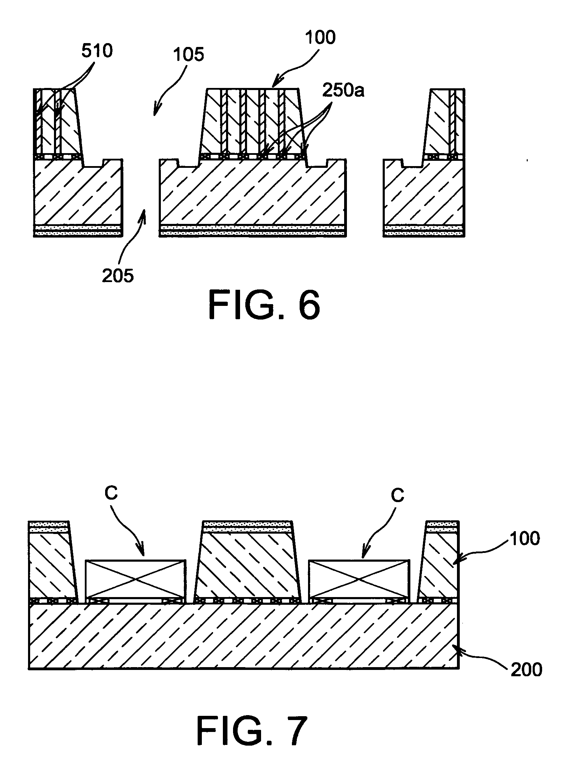

Sur la figure 6, une telle variante est illustrée. Le substrat 100 est pourvu d'éléments conducteurs 510 traversant l'épaisseur de ce dernier et qui sont en contact avec des zones 250a conductrices de l'interface de collage, lorsque cette dernière est formée par exemple d'une pluralité de zones métalliques disjointes.

Les éléments conducteurs traversant 510 peuvent avoir été formés au préalable, de sorte que le matériau de départ du procédé est un substrat 100 pourvu d'éléments conducteurs 510 traversant, ou après avoir réalisé une succession d'étapes de procédé telle que décrite précédemment.

Un tel agencement peut être utilisé par exemple pour des applications à des imageurs 3D dotés de plusieurs substrats interconnectés par l'intermédiaire de vias inter-substrats.

Après que les cavités 109 aient été réalisées dans le premier substrat 100, on peut disposer dans ces cavités 109 des composants C. Ces composants C peuvent être par exemple des puces électroniques ou des composants optiques, ou des MEMS (MEMS pour microsystèmes électromécaniques) (figure 7).

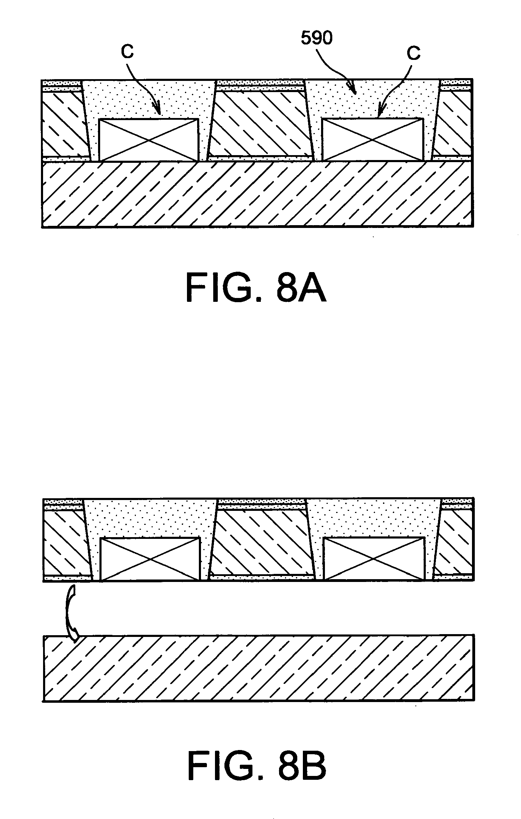

Un matériau d'enrobage 550 peut être ensuite disposé dans les cavités 109 pour protéger les composants C situés dans ces dernières (figure 8A). Le matériau d'enrobage peut être par exemple une résine d'encapsulation telle qu'une résine époxy et communément appelée « glop-top ».

Une étape de séparation des 2 substrats 100 et 200 peut être ensuite éventuellement réalisée

(figure 8B), par exemple par gravure de la couche de collage ou par utilisation d'une interface de collage temporaire.

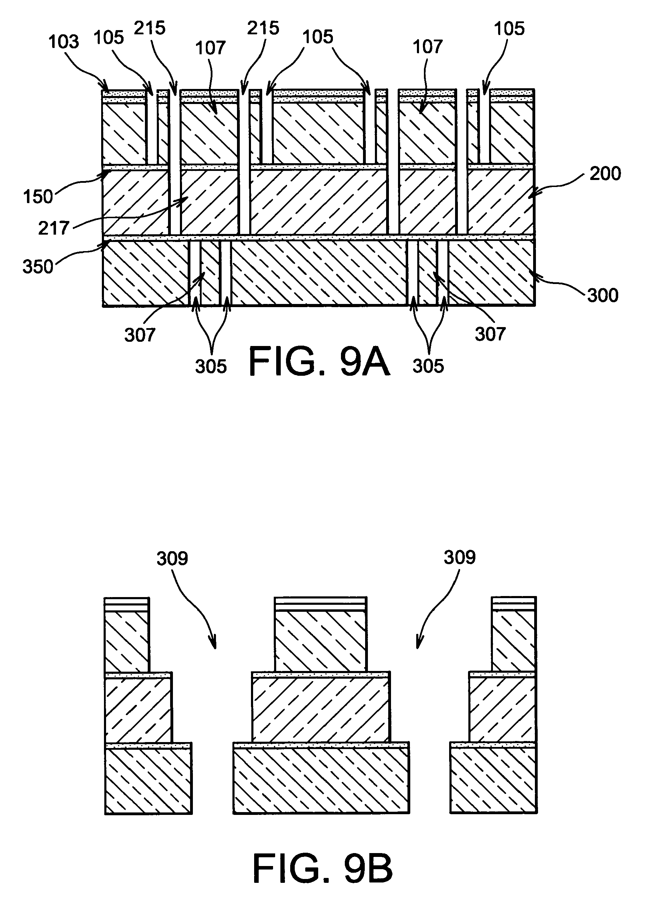

Un procédé suivant l'invention peut être mis en oeuvre sur plus de deux substrats. Sur les figures 9A-9B un exemple de procédé dans lequel des sites d'accueil de composants sont formés dans trois substrats 100, 200, 300 collés, est illustré.

A un substrat 100, on joint un deuxième substrat 200, par exemple par un procédé de collage tel qu'un collage moléculaire ou un collage par apport de matière.

Le collage des substrats 100 et 200 peut être réalisé à l'aide d'une couche 150 de collage entre les deux substrats 100 et 200, par exemple une couche formée d'une ou plusieurs épaisseurs de SiO₂ lorsque les substrats sont à base de Si.

Au substrat 200, on joint un troisième substrat 300, par exemple par un procédé de collage tel qu'un collage moléculaire ou un collage par apport de matière.

Le collage des substrats 200 et 300 peut être réalisé à l'aide d'une couche 350 de collage entre, par exemple une couche formée d'une ou plusieurs épaisseurs de SiO₂ lorsque les substrats 200 et 300 sont à base de Si.

Ensuite, on peut réaliser un masque 103 de gravure sur le substrat 100, en vue de graver ce dernier.

Puis, on forme une ou plusieurs tranchées 105 par gravure à travers le masque dans le premier substrat 100, entourant des blocs 107 sacrificiels, jusqu'à la couche 150 à l'interface de collage entre les substrats 100 et 200.

Les tranchées 105 forment chacune un contour autour d'un bloc 107 sacrificiel du substrat 100, qui est détouré et destiné à être retiré ultérieurement.

Ensuite, on peut former une ou plusieurs autres tranchées 215 par gravure à travers le masque 103 dans le premier substrat 100, de manière à traverser les blocs 107 sacrificiels.

Cette gravure peut être réalisée jusqu'à la couche 350 à l'interface de collage entre les substrats 200 et 300.

Les tranchées 215 peuvent former chacune un contour autour d'un bloc 217 sacrificiel du deuxième substrat 200, qui est détouré et destiné à être retiré ultérieurement.

Puis, de l'autre côté de l'assemblage de substrats 100-200-300, on peut former une ou plusieurs autres tranchées 305 dans le troisième substrat 300, en regard des blocs sacrificiels 107, 217 situés dans le premier substrat 100 et dans le deuxième substrat 200 et de manière à dévoiler la couche 350 de collage.

Cette gravure peut être réalisée jusqu'à la couche 350 à l'interface de collage entre les substrats 200 et 300.

Les tranchées 305 peuvent former chacune un contour autour d'un bloc 307 sacrificiel du troisième substrat 300, qui est détouré et destiné à être retiré ultérieurement (figure 9A).

Ensuite, on effectue un retrait des blocs sacrificiels 107, 207, 307. Le retrait peut être effectué par exemple par gravure isotrope d'une partie des couches 150 et 350 de collage, pour permettre le détachement des blocs sacrificiels 107, 217, 307.

Une fois les blocs sacrificiels retirés, des cavités 309 traversant les trois substrats 100, 200, 300 sont ainsi formées. Ces cavités 309 peuvent avoir des parois formant un profil en escalier.

Les cavités 309 peuvent servir de sites d'accueil à des composants, par exemple à des composants optiques (figure 9B).

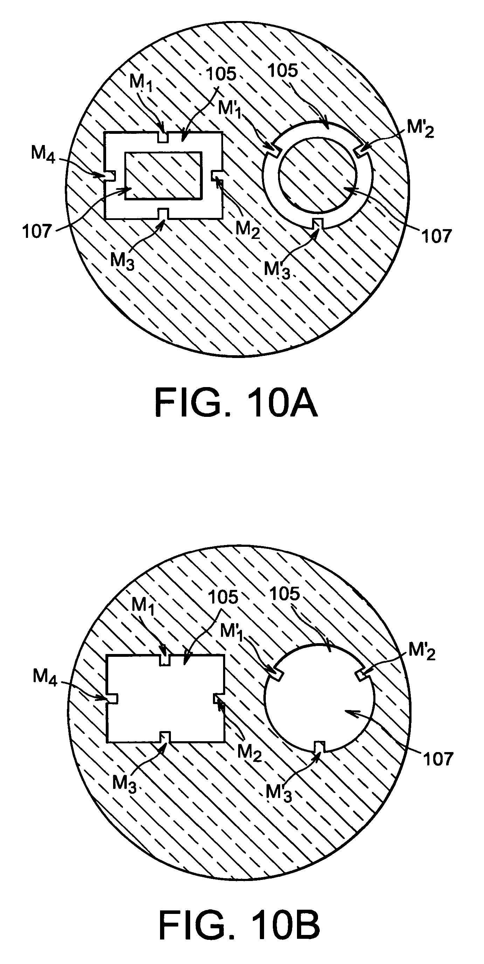

Selon une possibilité de mise en oeuvre de l'un ou l'autre des procédés décrits précédemment, lorsqu'on réalise les tranchées 105 de manière à détourer des blocs 107 sacrificiels dans le premier substrat 100, on peut prévoir de conserver sur les parois des tranchées 105, des motifs M₁, M₂, M₃, M₄, et M'_{1,} M'₂, M'₃ à base du matériau 101 du premier substrat, agencés de manière à former, des indicateurs visuels ou des mires indiquant par exemple le centre des blocs sacrificiels 107 lorsqu'ils n'ont pas été retirés (figure 10A). Les motifs M₁, M₂, M₃, M₄, et M'₁, M'₂, M'₃ à base du matériau 101 du premier substrat, peuvent être également agencés de manière à former des moyens de guidage indiquant par exemple le centre des blocs sacrificiels 107 lorsqu'ils n'ont pas été retirés (figure 10A).

Les motifs M₁, M₂, M₃, M₄, et M'₁, M'₂, M'₃ à base du matériau 101 peuvent indiquer le centre des cavités formant des sites d'accueil de composants lorsque les blocs sacrificiels ont été retirés (figure 10B) et éventuellement également de moyens de guidage pour permettre de réaliser un positionnement précis ou un auto-centrage de composants placés dans les cavités.

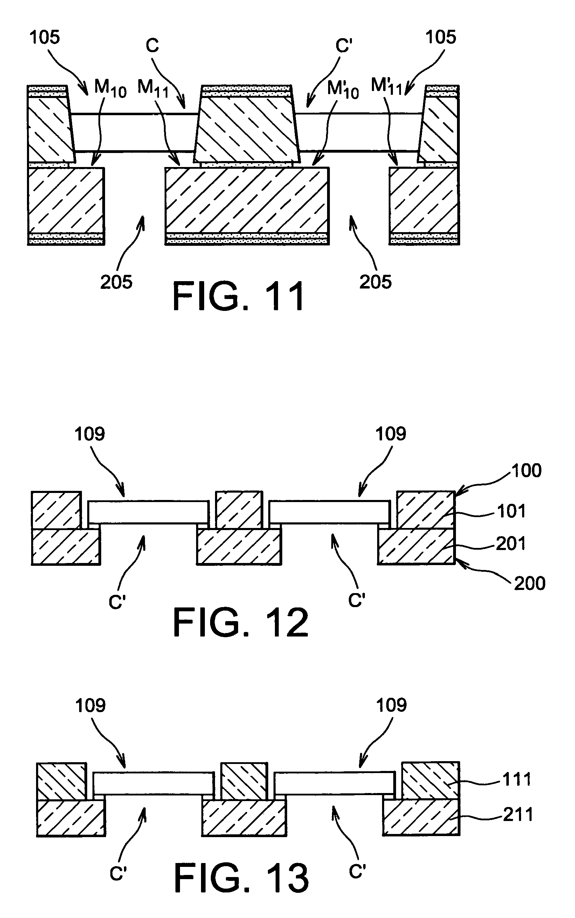

Il est également possible de réaliser des structures ou des motifs M₁₀, M₁₁, et M'₁₀, M'₁₁ formant des indicateurs visuels ou des mires de centrage, lors de réalisation de tranchées 205 dans le deuxième substrat 200 débouchant sur les tranchées 105 réalisées dans le premier substrat 100. Une fois les blocs sacrificiels retirés, l'espace laissé dans le substrat 100 et 200 par ces blocs, ainsi que les tranchées 105, 205, forme des cavités 109 traversant les deux substrats 100, 200, et formant des sites d'accueil pour des composants C, C' par exemple des composants optiques. Les motifs de centrage M₁₀, M₁₁, et M'₁₀, M'₁₁ peuvent permettre un positionnement plus aisé des composants C, C' lorsque ces derniers sont placés dans les cavités (figure 11).

Un exemple de dispositif mis en oeuvre à l'aide d'un procédé suivant l'invention, est donné sur la figure 12.

Ce dispositif comporte un premier substrat 100 à base d'un premier matériau 101 et collé à un deuxième substrat 200, à base du même matériau que le premier substrat 101. Des cavités 109, sont formées dans le premier substrat 100, et le deuxième substrat 200 et forment des sites d'accueil de composants C', par exemple des composants optiques tels que des filtres ou des lentilles.

Un autre exemple de dispositif mis en oeuvre à l'aide d'un procédé suivant l'invention est donné sur la figure 13 et diffère du précédent, en ce que le premier substrat 100 est à base d'un matériau 111 différent de celui du deuxième substrat 200.

Un procédé suivant l'invention tel que décrit dans l'un ou l'autre des exemples donnés précédemment, permet de réduire la durée globale des gravures nécessaire à la réalisation des sites d'accueil.

Un procédé suivant l'invention permet également de réaliser des structures avec des taux d'ouvertures importants et des sites d'accueil de composants dont l'erreur de précision du positionnement est inférieure à 5 µm.

## Revendications

1. Procédé de réalisation d'un micro-dispositif doté d'au moins une cavité (109, 109-209, 309), formée dans l'épaisseur d'un substrat (100, 200, 300), le procédé comprenant des étapes de :
a) réalisation dans au moins un premier substrat (100) assemblé à un deuxième substrat (200) par l'intermédiaire d'une interface, d'au moins une première tranchée (105) autour d'au moins un bloc sacrificiel (107) du premier substrat (100), par gravure du premier substrat (100) de manière à dévoiler ladite interface, et
b) retrait dudit bloc sacrificiel (107) de façon à réaliser au moins une première cavité (109) dans le premier substrat (100),
dans lequel le premier substrat (100) et le deuxième substrat (200) sont collés, ladite interface étant une interface de collage, et dans lequel l'interface de collage entre le premier substrat (100) et le deuxième substrat (200) est discontinue et comprend des zones (250a, 250c) à base d'au moins un matériau de collage et des zones (250b) formant un espace vide entre le premier et le deuxième substrat, et
dans lequel les blocs sacrificiels sont situés en regard de zones (250b) de l'interface formant un espace vide entre le premier substrat (100) et le deuxième substrat (200).

2. Procédé selon la revendication 1, dans lequel le premier substrat (100) et le deuxième substrat (200) sont formés de matériaux différents.

3. Procédé selon l'une quelconque des revendications 1 et 2, dans lequel l'interface de collage est une interface de collage moléculaire qui est structurée de façon à avoir des zones de collage moléculaire et des zones de vide, sans collage moléculaire.

4. Procédé selon l'une quelconque des revendications 1 à 3, dans lequel l'interface de collage entre le premier substrat (100) et le deuxième substrat (200) est discontinue et comprend des zones (250a) à base d'au moins un premier matériau de collage, et des zones (250c) à base d'au moins un deuxième matériau de collage, situées en regard des blocs sacrificiels.

5. Procédé selon l'une des revendications 1 à 4, dans lequel l'interface entre le premier substrat (100) et le deuxième substrat (200) comporte des zones (205a) électriquement conductrices.

6. Procédé selon l'une des revendications 1 à 5, comprenant en outre : la réalisation d'au moins une autre tranchée (205) dans le deuxième substrat (200) en regard dudit bloc sacrificiel (107) ou dans le prolongement de ladite première cavité (109).

7. Procédé selon la revendication 6, dans lequel l'autre tranchée (205) est réalisée autour d'un autre bloc sacrificiel (207) situé en regard dudit bloc sacrificiel (107), le procédé comprenant en outre le retrait dudit autre bloc sacrificiel (207) de manière à former une cavité dans le deuxième substrat (209) en regard dudit bloc sacrificiel (107) ou dans le prolongement de ladite première cavité (109).

8. Procédé selon l'une des revendications 1 à 7, le retrait dudit bloc sacrificiel (107) étant réalisé par gravure partielle de l'interface de collage.

9. Procédé selon l'une des revendications 1 à 8, après la réalisation de la tranchée, la formation d'une couche de protection (410) recouvrant le premier substrat (100), puis, préalablement à l'étape b), le retrait de la couche de protection (410) sur le bloc sacrificiel (107).

10. Procédé selon l'une des revendications 1 à 9, dans lequel l'interface de collage comporte des zones conductrices de l'électricité (250a), le premier substrat (100) et/ou le deuxième substrat (200) étant dotés d'éléments conducteurs (510) traversant, en contact avec lesdites zones conductrices (250a).

11. Procédé selon l'une des revendications 1 à 10, dans lequel, à l'étape a), la formation des tranchées (105) comprend la réalisation de motifs (M₁, M₂, M₃, M₄, M'₁, M'₂, M'₃) dans le premier substrat (100) formant un ou plusieurs repère visuels autour des blocs sacrificiels (107) et destinés à indiquer le centre des cavités (109) et/ou des moyens de guidage.

12. Procédé selon l'une des revendications 1 à 11, dans lequel le deuxième substrat (200) est assemblé à un troisième substrat (300) par l'intermédiaire d'une autre interface (350), le procédé comprenant en outre :
- la réalisation d'au moins une autre tranchée (215), traversant le bloc sacrificiel (107) du premier substrat (100), et prolongée dans le deuxième substrat (200) autour d'au moins un bloc sacrificiel (217) du deuxième substrat (200) jusqu'à l'autre interface (350) entre le deuxième substrat (200) et le troisième substrat (300), et
- la réalisation d'au moins une tranchée (305) autour d'au moins un bloc sacrificiel (307) du troisième substrat (300), par gravure, de manière à dévoiler l'autre interface (350), l'étape b) comprenant en outre des blocs sacrificiels (217, 307) du deuxième substrat (200) et du troisième substrat (300) de façon à réaliser une cavité (309) traversant le premier substrat (100), le deuxième substrat (200) et le troisième substrat (300).

13. Procédé selon l'une des revendications 1 à 12, comprenant en outre, après l'étape b), la réalisation d'au moins un élément (C1) dans la première cavité (100) tel qu'un composant électronique, RF, optoélectronique, ou de détection chimique ou biologique.

14. Procédé selon l'une des revendications 1 à 13, comprenant en outre, après l'étape b), la séparation du premier substrat (100) et du deuxième substrat (200).

## Patentansprüche

1. Verfahren zur Herstellung einer Mikrovorrichtung mit wenigstens einem Hohlraum (109, 109-209, 309), ausgebildet in der Dicke eines Substrats (100, 200, 300), folgende Verfahrensschritte umfassend :
a) Realisieren - in wenigstens einem ersten Substrat (100), zusammengebaut mit einem zweiten Substrat (200) mittels einer Zwischenschicht - wenigstens eines ersten Grabens (105) um wenigstens einen Opferblock (107) des ersten Substrats (100) herum, wobei man das erste Substrat (100) durchätzt bis zu der genannten Zwischenschicht, und
b) Abtragen des genannten Opferblocks (107), um wenigstens einen ersten Hohlraum (109) in dem ersten Substrat (100) zu realisieren,
bei dem das erste Substrat (100) und das zweite Substrat (200) zusammengeklebt sind, indem die genannte Zwischenschicht eine Klebezwischenschicht ist, und bei dem die Klebezwischenschicht zwischen dem ersten Substrat (100) und dem zweiten Substrat (200) diskontinuierlich ist und Zonen (250a, 250c) auf der Basis wenigstens eines Klebematerials umfasst, sowie Zonen (250b), die zwischen dem ersten und zweiten Substrat einen leeren Raum bilden, und
bei dem sich die Opferblöcke in Höhe von Zonen (250b) der Zwischenschicht befinden, die zwischen dem ersten Substrat (100) und dem zweiten Substrat (200) einen leeren Raum bilden.

2. Verfahren nach Anspruch 1, bei dem das erste Substrat (100) und das zweite Substrat (200) aus unterschiedlichen Materialien sind.

3. Verfahren nach einem der Ansprüche 1 und 2, bei dem die Klebezwischenschicht eine Molekularklebungs-Zwischenschicht ist, die derartig strukturiert ist, dass sie Molekularklebungszonen und Leerzonen ohne Molekularklebung aufweist.

4. Verfahren nach einem der Ansprüche 1 bis 3, bei dem die Klebezwischenschicht zwischen dem ersten Substrat (100) und dem zweiten Substrat (200) diskontinuierlich ist und Zonen (250a) auf der Basis wenigstens eines ersten Klebematerial sowie in Höhe der Opferblöcke befindliche Zonen (250c) auf der Basis wenigstens eines zweiten Klebematerials umfasst.

5. Verfahren nach einem der Ansprüche 1 bis 4, bei dem die Klebezwischenschicht zwischen dem ersten Substrat (100) und dem zweiten Substrat (200) elektrisch leitfähige Zonen (205a) umfasst.

6. Verfahren nach einem der Ansprüche 1 bis 5, außerdem umfassend : das Realisieren wenigstens eines anderen Grabens (205) in dem zweiten Substrat (200) in Höhe des genannten Opferblocks (107) oder in der Verlängerung des genannten ersten Hohlraums (109).

7. Verfahren nach Anspruch 6, bei dem der andere Graben (205) um einen anderen, dem genannten Opferblock (107) gegenüberstehenden Opferblock (207) herum realisiert wird, und das Verfahren außerdem das Abtragen des genannten anderen Opferblocks (207) umfasst, um in dem zweiten Substrat (209), gegenüber dem genannten Opferblock (107) oder in der Verlängerung des genannten ersten Hohlraums (109), einen Hohlraum zu bilden.

8. Verfahren nach einem der Ansprüche 1 bis 7, bei dem das Abtragen des genannten Opferblocks (107) durch partielles Ätzen der Klebezwischenschicht realisiert wird.

9. Verfahren nach einem der Ansprüche 1 bis 8, bei dem man nach dem Realisieren des Grabens das erste Substrat (100) mit einer Schutzschicht (410) überzieht und dann vordem Schritt b) die Schutzschicht (410) auf dem Opferblock (107) abträgt.

10. Verfahren nach einem der Ansprüche 1 bis 9, bei dem die Klebezwischenschicht elektrisch leitfähige Zonen (250a) umfasst, wobei das erste Substrat (100) und/oder das zweite Substrat (200) leitfähige Durchgangselemente (510), in Kontakt mit den genannten leitfähigen Zonen (250a), aufweisen.

11. Verfahren nach einem der Ansprüche 1 bis 10, bei dem, in Schritt a), die Ausbildung der Gräben (105) die Realisierung von Mustern (M₁, M₂, M₃, M₄, M'₁, M'₂, M'₃) in dem ersten Substrat (100) umfasst, die eine oder mehrere Markierungen um Opferblöcke 107) herum bilden und dazu bestimmt sind, auf den Mittelpunkt der Hohlräume (109) und/oder der Führungseinrichtungen hinzuweisen.

12. Verfahren nach einem der Ansprüche 1 bis 11, bei dem das zweite Substrat (200) mittels einer weiteren Zwischenschicht (350) mit einem dritten Substrat (300) zusammengebaut wird, wobei das Verfahren außerdem umfasst :
- die Realisierung wenigstens eines weiteren, den Opferblock (107) des ersten Substrats (100) durchquerenden Grabens (215), verlängert in das zweite Substrat (200), um wenigstens einen Opferblock (217) des zweiten Substrats (200) herum, bis zu der weiteren Zwischenschicht (350) zwischen dem zweiten Substrat (200) und dem dritten Substrat (300), und
- die Realisierung wenigstens eines Grabens (305) um wenigstens einen Opferblock (307) des dritten Substrats (300) herum durch Ätzung bis zu der weiteren Zwischenschicht (350), wobei der Schritt b) außerdem Opferblöcke (217, 307) des zweiten Substrats (200) und des dritten Substrats (300) umfasst, um einen das erste Substrat (100), das zweite Substrate (200) und das dritte Substrat (300) durchquerenden Hohlraum (309) zu realisierten.

13. Verfahren nach einem der Ansprüche 1 bis 12, außerdem, nach Schritt b), die Realisierung wenigstens eines Elements (C1) in dem ersten Hohlraum (100) umfassend, zum Beispiel eines Bauteils vom Typ RF, Optoelektronik oder chemische oder biologische Detektion.

14. Verfahren nach einem der Ansprüche 1 bis 13, außerdem, nach Schritt b), die Trennung des ersten Subsrats (100) und des zweiten Substrats (200) umfassend.

## Claims

1. A method for making a micro-device provided with at least one cavity (109, 109-209, 309), formed in the thickness of the substrate (100, 200,300), the method comprising the steps:
a) making in at least one first substrate (100) assembled to a second substrate (200) via an interface, at least one first trench (105) around at least one sacrificial block (107) of the first substrate (100), by etching the first substrate (100) so as to expose said interface, and
b) removing said sacrificial block (107) so as to make at least one first cavity (109) in the first substrate (100),
wherein the first substrate (100) and the second substrate (200) are adhesively bonded, said interface being an adhesive bonding interface and wherein the adhesive bonding interface between the first substrate (100) and the second substrate (200) is discontinuous and comprises areas (250a, 250c) based on at least one adhesive bonding material and areas (250b) forming an empty space between the first and the second substrate, and wherein the sacrificial blocks are located facing areas (250b) of the interface forming an empty space between the first substrate (100) and the second substrate (200).

2. The method according to claim 1, wherein the first substrate (100) and the second substrate (200) are formed with different materials.

3. The method according to any of claims 1 and 2, wherein the adhesive bonding interface is a molecular bonding interface which is structured so as to have molecular bonding areas and empty areas, without molecular bonding.

4. The method according to any of claims 1 to 3, wherein the adhesive bonding interface between the first substrate (100) and the second substrate (200) is discontinuous and comprises areas (250a) based on at least one first adhesive bonding material, and areas (250c) based on at least one second adhesive bonding material, located facing the sacrificial blocks.

5. The method according to any of claims 1 to 4, wherein the interface between the first substrate (100) and the second substrate (200) includes electrically conducting areas (205a).

6. The method according to one of claims 1 to 5, further comprising: the making of at least one other trench (205) in the second substrate (200) facing said sacrificial block (107) or in the extension of said first cavity (109).

7. The method according to claim 6, wherein the other trench (205) is made around another sacrificial block (207) located facing said sacrificial block (107), the method further comprising the removal of said other sacrificial block (207) so as to form a cavity in the second substrate (209) facing said sacrificial block (107) or in the extension of said first cavity (109).

8. The method according to one of claims 1 to 7, the removal of said sacrificial block (107) being achieved by partial etching of the adhesive bonding interface.

9. The method according to one of claims 1 to 8, after making the trench, the formation of a protective layer (410) covering the first substrate (100), and then prior to step b), removal of the protective layer (410) on the sacrificial block (107).

10. The method according to one of claims 1 to 9, wherein the adhesive bonding interface includes electrically conducting areas (250a), the first substrate (100) and/or the second substrate (200) being provided with conducting through-elements (510), in contact with said conducting areas (250a).

11. The method according to one of claims 1 to 10, wherein, in step a), the formation of the trenches (105) comprises the making of patterns (M₁, M₂, M₃, M₄, M'_{1,} M'₂, M'₃) in the first substrate (100) forming one or more visual marks around the sacrificial blocks (107) and intended to indicate the center of the cavities (109) and/or guiding means.

12. The method according to one of claims 1 to 11, wherein the second substrate (200) is assembled to a third substrate (300) via another interface (350), the method further comprising:
- the making of at least one other trench (215) crossing the sacrificial block (107) of the first substrate (100) and extended into the second substrate (200) around at least one sacrificial block (217) of the second substrate (200) as far as the other interface (350) between the second substrate (200) and the third substrate (300), and
- the making of at least one trench (305) around at least one sacrificial block (307) of the third substrate (300), by etching so as to expose the other interface (350), the step b) further comprising sacrificial blocks (217, 307) of the second substrate (200) and of the third substrate (300) so as to make a cavity (309) crossing the first substrate (100), the second substrate (200) and the third substrate (300).

13. The method according to one of claims 1 to 12, further comprising after step b), the making of at least one element (C1) in the first cavity (100) such as an electronic, RF, opto-electronic component, or a component for chemical or biological detection.

14. The method according to one of claims 1 to 13, further comprising after step b), the separation of the first substrate (100) and of the second substrate (200).
